# EUROPÄISCHE PATENTSCHRIFT

(11) **EP 2 039 800 B1**
(45) Veröffentlichungstag und Bekanntmachung des Hinweises auf die Patenterteilung: **17.08.2011**
(21) Anmeldenummer: 08014653.3
(22) Anmeldetag: 18.08.2008
(51) Int. Cl.: C23C 16/455, C23C 16/04

(54) **Plasmabehandlungsanlage**
Plasma treatment facility
Installation de traitement au plasma

(30) Priorität: 20.09.2007 DE 102007045141
(43) Veröffentlichungstag der Anmeldung: 25.03.2009
(73) Patentinhaber: Krones AG, 93073 Neutraubling (DE)
(72) Erfinder: Kraus, Andreas, 93049 Regensburg (DE); Krüger, Jochen, 93095 Hagelstadt (DE)
(74) Vertreter: Grünecker, Kinkeldey, Stockmair & Schwanhäusser Anwaltssozietät

(56) Entgegenhaltungen:
- US-A1- 2006 062 931

## Beschreibung

Die Erfindung bezieht sich auf eine Plasmabehandlungsanlage mit einer Behandlungskammer, in die zu behandelnde Flaschen verbringbar sind, mit einer Unterdruckkammer, mit einem an die Unterdruckkammer angeschlossenen Ventil, das im geöffneten Zustand den Innenbereich der Flasche über einen Absaugkanal mit der Unterdruckkammer verbindet und gegenüber der Behandlungskammer gasdicht abschließt, und mit einer Versorgungseinrichtung für ein Prozessgas.

Die Haltbarkeit von Getränken in PET-Flaschen wird durch die eingeschränkte Gasdichtigkeit der Flaschenwand auf ein unerwünschtes Maß reduziert. Dies gilt insbesondere für die Lagerung CO₂-haltiger Getränke. Es wurde daher bereits verschiedentlich versucht, die Gasdichtigkeit der Flaschenwand durch Plasmabeschichtung zu verbessern, z. B. durch Aufbringen einer Gassperrenschicht aus SiO₂.

Ein solches Verfahren ist z.B. aus der US 2005/0233077 A1 bekannt, bei dem bis zu zwei PET-Flaschen in einer gemeinsamen Behandlungskammer angeordnet und über je ein Anpressventil und eine gemeinsame Leitung evakuiert werden. Die Flaschen werden zu diesem Zweck zunächst an den Anpressventilen positioniert, wobei die Behandlungskammer bei geöffnetem Ventil jeweils mit dem Innenbereich der Flaschen verbunden ist. Das Ventil wird durch Anpressen der Flasche geschlossen und damit die Behandlungskammer gegenüber den Innenbereichen der Flaschen abgedichtet. Die Evakuierung der Flaschen und der Behandlungskammer sowie die Zufuhr des Prozessgases werden durch separate Ventile in den Leitungen geregelt.

Aus der US 6,328,805 B1 ist zudem eine Plasmabehandlungsanlage bekannt, bei der die Behandlungskammer und das Flascheninnere gemeinsam abgesaugt werden. Zwischen der Behandlungskammer und einem mit dem Flascheninneren verbundenen Bereich befindet sich ein Ventil, mit dem ein Differenzdruck eingestellt werden kann. Die Steuerung der Prozessgaszuführung erfolgt über ein gesondertes Ventil. Die Behandlungskammer kann jeweils nur eine Flasche aufnehmen und wird zwischen den Beschichtungsvorgängen geöffnet. Dabei gleicht sich der mit Hilfe des Ventils eingestellte Druckunterschied wieder aus.

Aus der EP 1 391 535 B1 ist weiterhin ein Anpressventil bekannt, das durch Anpressen der Flaschenmündung gegen das Ventil den Innen- und Außenbereich einer zu evakuierenden Flasche gegeneinander abdichtet.

Die US 2006/062931 A beschreibt eine Vorrichtung zur Plasmabehandlung von Kunststoffbehältern mit den Merkmalen des Oberbegriffs des Anspruchs 1.

Aufgabe der vorliegenden Erfindung ist es, eine vereinfachte Vorrichtung zur Beschichtung kontinuierlich zugeführter PET-Flaschen bereitzustellen, insbesondere eine Plasmabeschichtungsanlage mit einer vereinfachten Gasführung und weniger Steuerungsmechanismen.

Diese Aufgabe wird mit einer Vorrichtung nach Anspruch 1 und mit Verfahren nach den Ansprüchen 7 und 9 gelöst. Vorteilhafte Ausführungsformen sind in den Unteransprüchen offenbart.

Bei der vorliegenden Erfindung ist die Unterdruckkammer in der Behandlungskammer angeordnet, so dass eine Vielzahl von PET-Flaschen sukzessive in einer gemeinsamen Behandlungskammer evakuiert werden können. Da die Unterdruckkammer und die Behandlungskammer während des gesamten Beschichtungsvorgangs gegeneinander gasdicht abgeschlossen sind, kann ein konstanter Differenzdruck zwischen den Kammern aufrechterhalten werden. Da das Ventil durch Druck der Flaschenmündung gegen den Einlassbereich des Ventils geöffnet wird, kann das Ventil automatisch, z. B. entlang einer Hubkurve, geöffnet werden und somit ein separater Auslösemechanismus eingespart werden.

Vorteilhaft ist auch eine Ausgestaltung, bei der die Versorgungseinrichtung für ein Prozessgas bei geöffnetem Ventil über einen Versorgungskanal des Ventils mit dem Innenbereich der Flasche verbunden ist und der Versorgungskanal bei geschlossenem Ventil unterbrochen ist. Auf diese Weise kann ein zusätzlicher Steuerungsmechanismus für die Prozessgasführung eingespart werden.

Besonders vorteilhaft ist auch eine Ausgestaltung, bei der die Versorgungseinrichtung für das Prozessgas bei geschlossenem Ventil mit einem Entsorgungskanal des Ventils verbunden ist. In diesem Fall entfällt eine zusätzlich aufwendige Steuerung und Regelung des Prozessgasflusses für jedes einzelne Ventil, wenn dieses in großer Stückzahl in einen Rundläufer integriert wird.

In einer weiteren Ausführungsform ist der Entsorgungskanal des Ventils mit der Unterdruckkammer verbunden. In diesem Fall können zusätzliche abführende Leitungen eingespart werden.

Vorteilhaft ist auch eine Ausführungsform, bei der zwischen der Behandlungskammer und der Unterdruckkammer kontinuierlich eine Druckdifferenz besteht. Dies vereinfacht den Ablauf und die Kontrolle der Evakuierung.

Besonders vorteilhaft ist auch eine Ausgestaltung, bei der die Unterdruckkammer relativ zur Behandlungskammer drehbar gelagert ist. Dies erlaubt die Ausgestaltung der Behandlungskammer als Rundläufer, bei der die Flaschen kontinuierlich eingeschleust und an Einzelstationen beschichtet werden.

Bei einer besonders vorteilhaften Ausführungsform wird im Innenbereich der Flasche ein um 10 - 50 mbar geringerer Druck erzeugt als der in der Behandlungskammer herrschende Druck. Dadurch werden optimale Bedingungen für das Zünden des Plasmas im Flascheninneren geschaffen und sowohl ein Zünden des Plasmas im Außenbereich der Flasche als auch eine Verformung der Flasche durch einen zu hohen Druckunterschied vermieden.

Die Erfindung wird nachfolgend anhand des in der Zeichnung dargestellten Ausführungsbeispiels weiter erläutert. Dabei zeigt:
- Figur 1: die Plasmabehandlungsanlage in einer schematischen Schnitt-Ansicht;
- Figur 2: ein Ventil der Plasmabehandlungsanlage in geschlossenem Zustand in einer schematischen Schnitt-Ansicht;
- Figur 3: ein Ventil der Plasmabehandlungsanlage in geöffnetem Zustand in einer sche- matischen Schnitt-Ansicht.

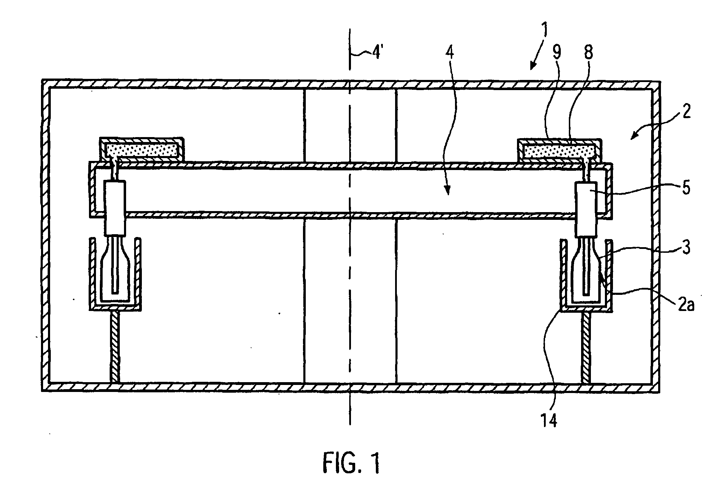

Figur 1 zeigt eine Plasmabehandlungsanlage 1 mit einer als Rundläufer ausgelegten Behandlungskammer 2 für die zu behandelnden Flaschen 3. In der Behandlungskammer 2 dreht sich eine im wesentlichen rotationssymmetrische Unterdruckkammer um die Achse 4'. Die Behandlungskammer 2 und die Unterdruckkammer 4 werden evakuiert, so dass zwischen beiden Kammern 2 und 4 kontinuierlich eine vorgegebene Druckdifferenz besteht.

Im zirkumferentiellen Randbereich der Unterdruckkammer 4 sind die Ventile 5, von denen in Figur 1 nur zwei beispielhaft gezeigt sind, ringförmig angeordnet. Auf der Oberseite der Unterdruckkammer 4 ist über jedem Ventil 5 je eine Versorgungseinrichtung 8 für ein Prozessgas 9 angeordnet. Figur 1 zeigt links eine unter dem Ventil 5 positionierte Flasche 3 und rechts eine gegen das Ventil 5 gepresste Flasche 3. Unter den zu behandelnden Flaschen 3 verläuft eine Ring- bzw. U-förmige Elektrode 14, die vorzugsweise aus Kupfer ausgebildet ist, aber mit einer Beschichtung bzw. einem Mantel aus beispielsweise Kunststoff versehen sein kann. Die Ausgestaltung der Elektrode 14 ist ausdrücklich nicht auf eine U-Form beschränkt. Die Flaschen werden mit konventioneller Technik, vorzugsweise einer Greifklammer gehalten und gegen das Ventil gedrückt. Dieser Vorgang kann mit einer Hubkurve oder mit anderen Mitteln z.B. mit Elektro- oder Pneumatikantrieben durchgeführt werden.

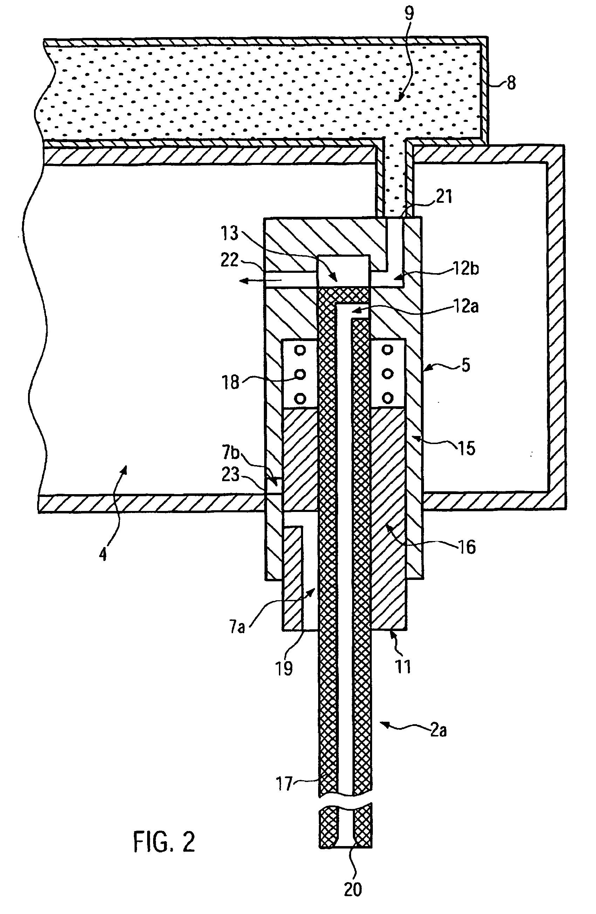

Figur 2 zeigt das Ventil 5 im geschlossenen Zustand, sowie die angrenzenden Bereiche der Unterdurckkammer 4 und der Versorgungseinrichtung 8 für das Prozessgas 9. Das Ventil 5 ist schematisch in einer dreiteiligen Form dargestellt, bestehend aus einem im wesentlichen zylinderförmigen Ventilkörper 15 und einem darin beweglichen Stempel 16, in dem das Rohr 17, das z.B. als röhrenförmiger Mikrowellenleiter oder als röhrenförmige Elektrode ausgebildet sein kann, befestigt ist. Der Übersichtlichkeit halber wurde auf die Darstellung zusätzlicher abdichtender Bauteile verzichtet. Die Vorspannung der Druckfeder 18 drückt den Stempel 16 in Richtung der Einlassöffnung 11 gegen einen nicht gezeigten Anschlag. Das Ventil 5 ist somit in der Ausgangsstellung geschlossen.

Die untere Stirnfläche des Stempels 16 bildet den Einlassbereich 11 des Ventils 5, mit der Absaugöffnung 19 und dem Absaugkanal 7a. Bei geschlossenem Ventil 5 endet der Absaugkanal 7a an der Wand des Ventilkörpers 15. Somit dichtet das geschlossene Ventil 5 die Behandlungskammer 2 gegen die Unterdruckkammer 4 gasdicht ab.

Die Innenwand des Rohrs 17 bildet den Versorgungskanal 12a für das Prozessgas 9. Da das obere Ende des Versorgungskanals 12a bei geschlossenem Ventil 5 ebenfalls an der Wand des Ventilkörpers 15 endet, ist der Versorgungskanal 12a bei geschlossenem Ventil 5 nicht mit der Versorgungseinrichtung 8 für das Prozessgas 9 verbunden.

Der obere Bereich des Ventilkörpers 15 weist eine mit der Versorgungseinrichtung 8 verbundene Einlassöffnung 21 für das Prozessgas 9 auf, die über den Versorgungskanal 12b und den Entsorgungskanal 13 mit der Auslassöffnung 22 verbunden ist. Im Ausführungsbeispiel führt die Auslassöffnung 22 direkt in die Unterdruckkammer 4, so dass das Prozessgas 9 bei geschlossenem Ventil 5 in diese geleitet wird. Alternativ könnte die Auslassöffnung 22 jedoch auch mit einer separaten, nicht gezeigten Entsorgungseinrichtung für das Prozessgas 9 verbunden werden.

Durch diese Führung des Prozessgasflusses entfällt eine aufwendige Steuerung und Regelung des Prozessgasflusses für jedes einzelne Ventil, wenn dieses in großer Stückzahl in einen Rundläufer integriert wird. Es ist jedoch auch denkbar, die Gaszufuhr durch mechanische, elektrische oder pneumatische Absperrvorrichtungen, die an die Stellung des Ventils gekoppelt sind, zu unterbrechen.

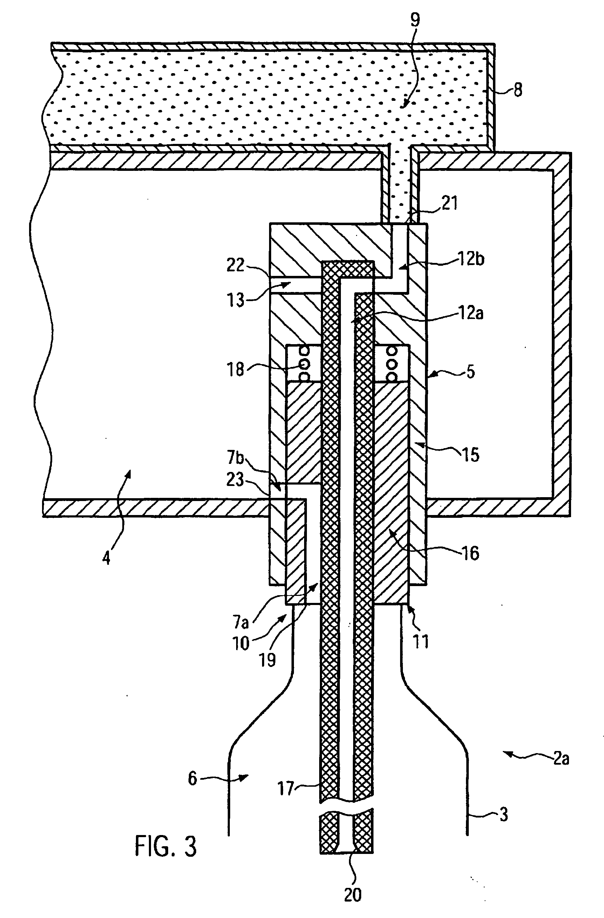

Figur 3 zeigt das Ventil 5 bei angeschlossener Flasche 3 und in geöffnetem Zustand. Im Unterschied zur Figur 2 wird der Stempel 16 durch Druck der Flaschenmündung 10 gegen den Einlassbereich 11 gegen die Kraft der Druckfeder 18 nach oben gedrückt. Dadurch wird eine Verbindung zwischen dem Absaugkanal 7a im Stempel 16 und dem Absaugkanal 7b und der Auslassöffnung 23 in der Wand des Ventilkörpers 15 hergestellt. Bei geöffnetem Ventil erfolgt somit Druckausgleich zwischen der Unterdruckkammer 4 und dem Innenbereich 6 der Flasche 3.

Der Einlassbereich 11 des Ventils 5 ist mit einem geeigneten Dichtungselement, z. B. einem flexiblen Dichtring, versehen, das den Innenbereich 6 der Flasche 3 gegenüber der Behandlungskammer 2 gasdicht abschließt.

Gleichzeitig wird der Versorgungskanal 12a über den Versorgungskanal 12b mit der Einlassöffnung 21 verbunden und die Verbindung zwischen dem Versorgungskanal 12b und dem Entsorgungskanal 13 unterbrochen. Das Prozessgas 9 wird folglich durch das Rohr 17 und die Auslassöffnung 20 in den Innenbereich 6 der Flasche 3 geleitet und ein Eindringen des Prozessgases 9 in die Behandlungskammer 2 durch die Abdichtung der Flaschenmündung 10 am Einlassbereich 11 verhindert.

Der Stempel 16 kann zudem als drehbar gelagertes Teil ausgeführt sein welches eine Drehung der Flasche 3 während des Prozesses ermöglicht.

Wird die Flasche 3 wieder abgesenkt, schließt sich das Ventil durch die Vorspannung der Druckfeder 18 selbsttätig, so dass die Verbindung zwischen den Kanalabschnitten 7a und 7b sowie 12a und 12b unterbrochen wird, solange die Flaschenmündung 10 noch gasdicht mit dem Einlassbereich 11 abschließt. Dadurch wird verhindert, dass Prozessgas 9 in die Behandlungskammer 2 eindringen kann und ein Druckausgleich zwischen der Behandlungskammer 2 und der Unterdruckkammer 4 stattfindet. Gleichzeitig wird überschüssiges Prozessgas in die Unterdruckkammer 4 geleitet.

Im Folgenden wird die Funktionsweise des in der Zeichnung dargestellten Ausführungsbeispiels einer erfindungsgemäßen Plasmabeschichtungsanlage erläutert.

Die zu behandelnden Flaschen 3 werden durch eine Druckschleuse kontinuierlich in die auf ein vorgegebenes Maß evakuierte Behandlungskammer 2 eingeschleust und von Haltevorrichtungen, die in geeigneter Weise an die sich drehende Unterduckkammer 4 gekoppelt sind, mitgenommen, so dass je eine Flasche 3 unter einem Ventil 5 positioniert ist. Die Flaschen 3 werden entlang einer Hubkurve weitertransportiert und auf diese Weise mit ihrer Flaschenmündungen 10 gegen die Einlassbereiche 11 der Ventile 5 gepresst, wodurch diese geöffnet werden.

Die einzelnen, an die geöffneten Ventile 5 angeschlossenen Flaschen 3 sind jeweils über die Absaugkanäle 7a und 7b an die gemeinsame Unterdruckkammer 4 angeschlossen und werden über eine vorgegebene Zeitspanne bis zu einem vorgegebenen Druck evakuiert.

Bei gleichzeitiger Abdichtung der Flaschenmündung 10 wird dadurch eine Druckdifferenz zwischen dem Innenbereich 6 der Flasche 3 und der Behandlungskammer 2 erzeugt, so dass außerhalb der Flasche 3 ein Plasma nicht zünden kann, da der Außendruck dazu entweder zu niedrig oder zu hoch ist, während der Druck im Flascheninneren 6 für einen Plasmaprozess optimal ist.

Während der Evakuierung der Flasche 3 wird das Prozessgas 9 für die Plasmabehandlung über den Versorgungskanal 12a, 12b in die Flasche 3 geleitet. Dabei soll in der Flasche 3 unter einer Gaslast von etwa 50 sccm Prozessgas 9 (unter europäischen Normbedingungen) ein Druck von etwa 0,1 mbar herrschen.

Da zwischen der Behandlungskammer 2 und der Unterdruckkammer 4 eine kontinuierlich aufrechterhaltener Druckdifferenz besteht, werden die für das Zünden des Plasmas geeigneten Bedingungen in allen Flaschen 3 nach einer näherungsweise konstanten Zeitspanne erreicht, nach deren Ablauf die jeweilige Flasche 3 durch Zünden des Plasmas beschichtet wird.

Im Ausführungsbeispiel soll nur die Innenwand der Flasche 3 durch einen Plasmaprozess behandelt werden. Außerhalb der Flasche 3 soll ein Druck herrschen, bei dem kein Plasma mehr zünden kann. Dazu geeignet ist z.B. ein relativer Überdruck von etwa 10 mbar gegen den Druck im Innenbereich 6 der Flasche 3. Allerdings darf der relative Überdruck auch nicht zu hoch sein, so dass eine PET-Einwegflasche nicht zusammengepresst werden kann, also kleiner als etwa 40 - 50 mbar gegen den Innendruck.

Abhängig vom Druckunterschied zwischen der Behandlungskammer 2 und Unterdruckkammer 4 kann aber auch erreicht werden, dass das Plasma nur außerhalb und nicht innerhalb der Flasche 3 zündet.

Nach erfolgter Beschichtung werden die Flaschen 3 entlang einer fallenden Hubkurve wieder abgesenkt und über eine Druckschleuse ausgeschleust.

## Patentansprüche

1. Plasmabehandlungsanlage (1) mit:
- einer Behandlungskammer (2), in die zu behandelnde Flaschen (3) verbringbar sind;
- einer Unterdruckkammer (4);
- einem an die Unterdruckkammer (4) angeschlossenen Ventil (5), wobei die Unterdruckkammer (4) bei geschlossenem Ventil (5) gegenüber der Behandlungskammer (2) gasdicht abgeschlossen ist; und mit
- einer Versorgungseinrichtung (8) für ein Prozessgas (9),
**dadurch gekennzeichnet,**
- **dass** die Unterdruckkammer (4) in der Behandlungskammer (2) angeordnet ist;
- **dass** das Ventil (5) im geöffneten Zustand den Innenbereich (6) der Flasche (3) über einen Absaugkanal (7a, 7b) mit der Unterdruckkammer (4) verbindet und gegenüber der Behandlungskammer (2) gasdicht abschließt; und
- **dass** das Ventil (5) so ausgebildet ist, dass es durch einen vorgegebenen Druck der Flaschenmündung (10) gegen einen Einlassbereich (11) des Ventils (5) geöffnet wird.

2. Plasmabehandlungsanlage nach Anspruch 1,
**dadurch gekennzeichnet, dass**
die Versorgungseinrichtung (8) für das Prozessgas (9) bei geöffnetem Ventil (5) über einen Versorgungskanal (12a, 12b) des Ventils (5) mit dem Innenbereich (6) der Flasche (3) verbunden ist und der Versorgungskanal (12a, 12b) bei geschlossenem Ventil (5) unterbrochen ist.

3. Plasmabehandlungsanlage nach Anspruch 2,
**dadurch gekennzeichnet**, das
die Versorgungseinrichtung (8) für das Prozessgas (9) bei geschlossenem Ventil (5) mit einem Entsorgungskanal (13) des Ventils (5) verbunden ist.

4. Plasmabehandlungsanlage nach Anspruch 3,
**dadurch gekennzeichnet, dass**
der Entsorgungskanal (13) des Ventils (5) mit der Unterdruckkammer (4) verbunden ist.

5. Plasmabehandlungsanlage nach Anspruch 1,
**dadurch gekennzeichnet, dass**
zwischen der Behandlungskammer (2) und der Unterdruckkammer (4) kontinuierlich eine Druckdifferenz besteht.

6. Plasmabehandlungsanlage nach Anspruch 1,
**dadurch gekennzeichnet, dass**
die Unterdruckkammer (4) relativ zur Behandlungskammer (2) drehbar gelagert ist.

7. Verfahren zur Plasmabehandlung von Flaschen mit einer Vorrichtung nach einem der Ansprüche 1 bis 6,
**dadurch gekennzeichnet, dass**
zur Innenbeschichtung einer Flasche (3) der Druck in der Behandlungskammer (2) so eingestellt wird, dass ein Plasma nicht zünden kann und dass der Druck in der Unterdruckkammer so eingestellt wird, dass im Innenbereich (6) der angeschlossenen Flasche (3) ein Plasma entsteht.

8. Verfahren zur Plasmabehandlung von Flaschen nach Anspruch 7,
**dadurch gekennzeichnet, dass**
im Innenbereich (6) der Flasche (3) ein um 10 - 50 mbar geringerer Druck erzeugt wird als der in der Behandlungskammer (2) herrschende Druck.

9. Verfahren zur Plasmabehandlung von Flaschen mit einer Vorrichtung nach einem der Ansprüche 1 bis 6,
**dadurch gekennzeichnet, dass**
zur Außenbeschichtung einer Flasche (3) der Druck in der Unterdruckkammer (4) so eingestellt wird, dass ein Plasma nicht zünden kann und dass der Druck in der Behandlungskammer (2) so eingestellt wird, dass im Außenbereich (2a) der angeschlossenen Flasche (3) ein Plasma entsteht.

## Claims

1. Plasma treatment facility (1), comprising:
- a treatment chamber (2), into which bottles (3) to be treated can be fed;
- a vacuum chamber (4);
- a valve (5) connected to the vacuum chamber (4), whereby the vacuum chamber (4) is closed off from the treatment chamber (2) in a gas-tight arrangement when the valve (5) is closed; and comprising
- a supply unit (8) for a process gas (9),
**characterised in that**
- the vacuum chamber (4) is disposed in the treatment chamber (2);
- in the opened state, the valve (5) connects the interior (6) of the bottle (3) to the vacuum chamber (4) via a suction passage (7a, 7b) and closes it off from the treatment chamber (2) in a gas-tight arrangement; and
- the valve (5) is designed so that it is opened by a predefined pressure of the bottle mouth (10) against an inlet region (11) of the valve (5).

2. Plasma treatment facility as claimed in claim 1,
**characterised in that**
the supply unit (8) for the process gas (9) is connected to the interior (6) of the bottle (3) via a supply passage (12a, 12b) of the valve (5) when the valve (5) is opened and the supply passage (12a, 12b) is shut off when the valve (5) is closed.

3. Plasma treatment facility as claimed in claim 2,
**characterised in that**
the supply unit (8) for the process gas (9) is connected to a discharge passage (13) of the valve (5) when the valve (5) is closed.

4. Plasma treatment facility as claimed in claim 3,
**characterised in that**
the discharge passage (13) of the valve (5) is connected to the vacuum chamber (4).

5. Plasma treatment facility as claimed in claim 1,
**characterised in that**
a pressure difference prevails continuously between the treatment chamber (2) and the vacuum chamber (4).

6. Plasma treatment facility as claimed in claim 1,
**characterised in that**
the vacuum chamber (4) is mounted so as to be rotatable relative to the treatment chamber (2).

7. Method of treating bottles with plasma using a device as claimed in one of claims 1 to 6,
**characterised in that**
in order to coat the interior of a bottle (3), the pressure in the treatment chamber (2) is set so that a plasma is not able to ignite and the pressure in the vacuum chamber is set so that a plasma is generated in the interior (6) of the connected bottle (3).

8. Method of treating bottles with plasma as claimed in claim 7,
**characterised in that**
a pressure generated in the interior (6) of the bottle (3) is lower than the pressure prevailing in the treatment chamber (2) by 10 - 50 mbar.

9. Method of treating bottles with plasma using a device as claimed in one of claims 1 to 6,
**characterised in that**
in order to coat the exterior of a bottle (3), the pressure in the vacuum chamber (4) is set so that a plasma is not able to ignite, and the pressure in the treatment chamber (2) is set so that a plasma is generated in the exterior region (2a) of the connected bottle (3).

## Revendications

1. Installation de traitement au plasma (1) avec :
- une chambre de traitement (2) dans laquelle des bouteilles à traiter (3) peuvent être amenées ;
- une chambre à dépression (4) ;
- une soupape (5) reliée à la chambre à dépression (4), étant précisé que la chambre à dépression (4), quand la soupape (5) est fermée, est fermée de manière étanche au gaz (2) par rapport à la chambre de traitement (2) ; et
- un dispositif d'alimentation (8) pour un gaz de traitement (9),
**caractérisée**
- **en ce que** la chambre à dépression (4) est disposée dans la chambre de traitement (2) ;
- **en ce que** la soupape (5), en position ouverte, relie la zone intérieure (6) de la bouteille (3) à la chambre à dépression (4) par l'intermédiaire d'un conduit d'aspiration (7a, 7b) et la ferme de manière étanche au gaz par rapport à la chambre de traitement (2) ; et
- **en ce que** la soupape (5) est conçue pour être ouverte par une pression prédéfinie du goulot (10) de la bouteille contre la zone d'entrée (11) de la soupape (5).

2. Installation de traitement au plasma selon la revendication 1, **caractérisée en ce que** le dispositif d'alimentation (8) pour le gaz de traitement (9), quand la soupape (5) est ouverte, est relié par un conduit d'alimentation (12a, 12b) de ladite soupape (5) à la zone intérieure (6) de la bouteille (3), et le conduit d'alimentation (12a, 12b), quand la soupape (5) est fermée, est coupé.

3. Installation de traitement au plasma selon la revendication 2, **caractérisée en ce que** le dispositif d'alimentation (8) pour le gaz de traitement (9), quand la soupape (5) est fermée, est relié à un conduit d'évacuation (13) de ladite soupape (5).

4. Installation de traitement au plasma selon la revendication 3, **caractérisée en ce que** le conduit d'évacuation (13) de la soupape (5) est relié à la chambre à dépression (4).

5. Installation de traitement au plasma selon la revendication 1, **caractérisée en ce qu'**il y a une différence de pression continuelle entre la chambre de traitement (2) et la chambre à dépression (4).

6. Installation de traitement au plasma selon la revendication 1, **caractérisée en ce que** la chambre à dépression (4) est montée en rotation par rapport à la chambre de traitement (2).

7. Procédé pour le traitement au plasma de bouteilles avec un dispositif selon l'une des revendications 1 à 6, **caractérisé en ce que** pour le revêtement interne d'une bouteille (3), la pression dans la chambre de traitement (2) est réglée de telle sorte qu'un plasma ne puisse pas se former et **en ce que** la pression dans la chambre à dépression est réglée de telle sorte qu'un plasma se forme dans la zone intérieure (6) de la bouteille (3) raccordée.

8. Procédé pour le traitement au plasma de bouteilles selon la revendication 7, **caractérisé en ce que** dans la zone intérieure (6) de la bouteille (3) est produite une pression inférieure de 10-50 mbar à la pression qui règne dans la chambre de traitement (2).

9. Procédé pour le traitement au plasma de bouteilles avec un dispositif selon l'une des revendications 1 à 6, **caractérisé en ce que** pour le revêtement externe d'une bouteille (3), la pression dans la chambre à dépression (4) est réglée de telle sorte qu'un plasma ne puisse pas se former et **en ce que** la pression dans la chambre de traitement (2) est réglée de telle sorte qu'un plasma se forme dans la zone extérieure (2a) de la bouteille (3) raccordée.
